(19) Europäisches Patentamt
European Patent Office
Office européen des brevets

(11) EP 0 436 174 B1

(12) **EUROPÄISCHE PATENTSCHRIFT**

(45) Veröffentlichungstag und Bekanntmachung des Hinweises auf die Patenterteilung:
**27.03.1996 Patentblatt 1996/13**

(51) Int Cl.$^6$: **G03F 7/038**

(21) Anmeldenummer: **90124480.6**

(22) Anmeldetag: **18.12.1990**

(54) **Strahlungsempfindliches Gemisch und Verfahren zur Herstellung von Reliefstrukturen**

Radiation sensitive mixture and process for the production of relief structures

Mélange sensible à l'irradiation et procédé de production de structures en relief

(84) Benannte Vertragsstaaten:
**BE DE FR GB IT NL**

(30) Priorität: **30.12.1989 DE 3943413**

(43) Veröffentlichungstag der Anmeldung:
**10.07.1991 Patentblatt 1991/28**

(73) Patentinhaber: **BASF Aktiengesellschaft**
**D-67063 Ludwigshafen (DE)**

(72) Erfinder: **Son, Nguyen Kim, Dr.**
**D-6944 Hemsbach (DE)**

(56) Entgegenhaltungen:
**EP-A- 3 424 498** **EP-B- 0 282 724**
**DE-A- 1 447 016** **US-A- 4 912 018**

EP 0 436 174 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

Printed by Jouve, 75001 PARIS (FR)

## Beschreibung

Die Erfindung betrifft strahlungsempfindliche Gemische, die negativ arbeitend sind, ein in Wasser unlösliches, in wäßrig-alkalischen Lösungen lösliches Bindemittel, eine unter Einwirkung von Strahlung eine Säure bildende Verbindung und organische Verbindungen, die in Gegenwart von Säure zur Kondensation befähigt sind, enthalten. Diese Gemische sind sensitiv gegenüber UV-, Elektronen- und Röntgenstrahlen und eignen sich besonders als Resistmaterial.

Negativ arbeitende strahlungsempfindliche Gemische sowie Verfahren zur Bildherstellung mittels dieser Gemische sind bekannt. Unter negativ arbeitenden Photoresists werden dabei solche verstanden, bei denen nach der bildmäßigen Belichtung der lichtempfindlichen Schicht die belichteten Bereiche dieser Schicht, gegebenenfalls nach einer zusätzlichen Wärmebehandlung, in der Entwicklerlösung, in der sie vor der Belichtung löslich waren, unlöslich sind.

Im allgemeinen basieren negativ arbeitende Photoresists auf photopolymerisierbaren Gemischen, die neben einem polymeren Bindemittel eine photopolymerisierbare Verbindung und einen Photoinitiator enthalten. Die am meisten verwendeten negativ arbeitenden Photoresists für die Herstellung integrierter Schaltungen enthalten fast ausnahmslos partiell cyclisiertes Polyisopren als vernetzbare Komponente und eine Diazid-Verbindung als lichtempfindlichen difunktionellen Vernetzer. Als Diazide sind hierbei solche der Struktur (A)

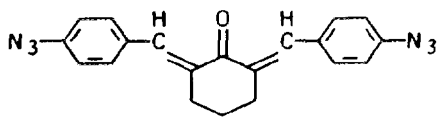

(A)

sehr gebräuchlich.

Neuerdings sind auch negativ arbeitende Photoresists, die aus teilcyclisiertem Polybutadien und Diaziden bestehen, im Handel erhältlich (vgl. auch Harita, Y., Ichigawa, M., Harada, K., Polym. Eng. Sci., 17 (1977), 372).

Eine Reihe negativ arbeitender Photoresists beasiert auch auf der Photodimerisierung als Vernetzungsreaktion. Hierher gehören die Zimtsäurederivate und die ihnen im Aufbau verwandten Chalkone. Die Vernetzungsreaktion verläuft im wesentlichen als lichtinduzierte [2+2]-Cycloaddition unter Bildung von Cyclobutanen (vgl. Williams, J.L.R.: Fortschr. Chem. Forsch., <u>13</u> (1969), 227; Reiser, A., Egerton, P.L.: Photogr. Sci. Eng., <u>23</u> (1979), 144; M. Kato et al: J. Polym. Sci. part B, Polym. Lett. Ed. <u>8</u> (1970), 263; M. Kato et al: Photogr. Sci. Eng., <u>23</u> (1979), 207).

In den letzten Jahren hat auch noch ein schon längere Zeit bekannter Typ photodimerisierbarer Epoxidharze als Photoresist Verwendung gefunden (vgl. z.B. DE-A-14 47 016; DE-A-23 42 407; DE-A-25 53 346 sowie DE-A-24 49 926). Diese Harze tragen sowohl Gruppierungen, die Photocycloadditionen ermöglichen, z.B. Chalkonreste, als auch Epoxygruppen, die thermisch katalysiert nachvernetzt werden können (vgl. Photoresist, New York,: McGraw Hill (1975); GB-PS 892 111 und US-S 2 852 379).

Außer den negativ arbeitenden Photoresisten, die ein Diazid der oben genannten Struktur (A) enthalten, sind die Photoreaktionen nur im NUV-Bereich (d.h. bei 350 bis 450 nm) möglich. Neue Diazidverbindungen für den kurzwelligen UV-Bereich wurden in den letzten Jahren beschrieben. Dazu gehören Ketonverbindungen (vgl. J. Elektrochem. Soc. (1981) 6) sowie schwefelhaltige Diazidverbindungen (vgl. J. Elektrochem. Soc., 127 (1980), 2759).

Auch negativ arbeitende wäßrig-alkalisch entwickelbare Photoresists, die im kurzwelligen UV strukturierbar sind, sind bekannt. Hierzu werden Poly-(p-vinylphenol) als Bindemittel und 3,3'-Diazidodiphenylsulfon verwendet (vgl. IEEE Trans. Electron Devices, ED. 28 (1981), 1306; IEEE Trans. Electron Devices, ED-28 (1981), 1284). Ein weiterer wäßrig-alkalisch entwickelbarer negativ arbeitender Photoresist basiert auf einem Oniumsalz und Methylacrylamidoglycolatmethylether (vgl. Hult et al; Polymers for high Tech. ACS Symposium Series 346 (1987), 162 bis 169), der auf dem Prinzip der säurekatalytischen Selbst-Kondensation zur Vernetzung des Bindemittels beruht.

Eine weitere photopolymerisierbare Zusammensetzung, die auf einem säurehärtbaren Material und einem Jodoniumalz als Säurespender basiert, ist aus der DE-A-2 602 574 bekannt.

Auch säurekatalytische Vernetzer, zu denen beispielsweise die als Zwischenprodukte bei der Kondensation von Phenol/Formaldehyd-Harz enthältlichen Arylmethylolverbindungen gehören, waren bereits bekannt (vgl. Progr. Org. Coat. 9 (1981), 107; DE-A-29 04 961; Plastics and Rubber Processing and Application 1 (1981), 39; DE-A-32 47 754; EP-A-01 39 309; JP 3051424-A). Auch für photostrukturierbares Aufzeichnungsmaterial hat dieser säurekatalytische Vernetzer Anwendung gefunden. In EP-A-0282724 wird über ein neues negativ arbeitendes System, das auf Poly(p-hydroxystyrol), einem Säurespender und einem Vernetzer mit mindestens zwei geschützten Methylolgruppen basiert, berichtet; anstelle Poly(p-hydroxystyrol) kann auch m-Kresol-Formaldehyd-Harz eingesetzt werden. Analog wurde in PCT/US 87/02743 ein anderes Negativ-System beschrieben, in dem auch Poly(p-hydroxystyrol) oder m-Kresol-Formaldehyd-Novolake als Bindemittel, ein 1,2-Chinondiazid als Säurespender und ein 2,6-Dimethylol-p-Kresol als Vernetzer eingesetzt werden (vgl. auch Photopolymers, Principles-Processes and Materials, 63-70 (1988)). Nachteile der beiden obengenannten Systeme sind: Haftungsabfall bei überbelichtung und Restschichtbildung, bzw. zu geringe Empfindlichkeit.

Aufgabe der vorliegenden Erfindung war es, neue hochaktive strahlungsempfindliche Systeme für die Herstellung

von im kurzwelligen UV lichtempfindlichen Schichten aufzuzeigen, die sich mit wäßrig-alkalischen Lösungen entwickeln lassen und Strukturen im Submikronbereich herzustellen erlauben, die thermisch und gegenüber Plasma stabil sind.

Überraschenderweise läßt sich diese Aufgabe sehr vorteilhaft durch die Kombination bestimmter Substanzen, die alle phenolische Hydroxylgruppen enthalten, lösen.

Gegenstand der vorliegenden Erfindung ist ein strahlungsempfindliches Gemisch, im wesentlichen bestehend aus

(a) einem in Wasser unlöslichen, in wäßrig-alkalischen Lösungen löslichen Bindemittel oder Bindemittelgemisch,

(b) einer bei Bestrahlung eine starke Säure bildenden Verbindung und

(c) mindestens einer in Gegenwart von Säure zur Kondensation befähigten organischen Verbindung,
das dadurch gekennzeichnet ist, daß jede der Komponenten (a), (b) und (c) mindestens eine phenolische Hydroxylgruppe enthält.

Das Bindemittel (a) kann vorzugsweise phenolisches Harz, das an den Phenolkernen eine oder mehrere freie o- und/oder p-Stellungen aufweist, ein kurzkettiger p-Kresol/Formaldehyd-Novolak mit einem mittleren Molekulargewicht $\overline{M}_w$ zwischen 150 und 1500, ein p-substituierter Kresol/Formaldehyd-Novolak, der im wesentlichen aus Einheiten der allgemeinen Formeln

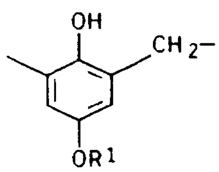

und

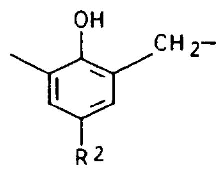

besteht, worin

$R^1$ für Alkyl, Aryl oder Aralkyl,
$R^2$ für $OR^1$, Alkyl oder Aralkyl stehen,
und ein mittleres Molekulargewicht $\overline{M}_w$ zwischen 200 und 5000 aufweist, insbesondere ein Poly-(p-hydroxistyrol) oder Poly-(p-hydroxi-α-methylstyrol) mit mittleren Molekulargewichten $\overline{M}_w$ zwischen 200 und 30.000, oder auch ein Gemisch aus mindesten zwei der oben genannten Bindemittel sein und im allgemeinen in einer Menge von 50 bis 95 Gew.%, bezogen auf die Gesamtmenge des strahlungsempfindlichen Gemisches, enthalten sein.

Als bei Bestrahlung eine starke säurebildende Verbindung (b) werden vorzugsweise Oniumsalze der allgemeinen Formel (I)

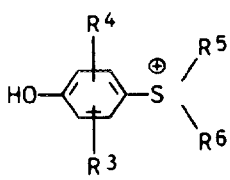

$X^{\ominus}$ (I),

worin $R^3$ und $R^4$ untereinander gleich oder verschieden sind und für H, OH, Alkyl oder Alkoxi mit 1 bis 4 Kohlenstoffatomen stehen, $R^4$ und $R^5$ untereinander gleich oder verschieden sind und für Methyl, Ethyl, Phenyl oder den Rest

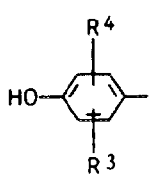

stehen und
$x^{\ominus}$ für $AsF_6^{\ominus}$, $PF_6^{\ominus}$ , $SbF_6^{\ominus}$, $BF_4^{\ominus}$ oder $CF3SO_3^{\ominus}$ steht, eingesetzt, wobei diese Komponente (b) im allgemeinen in Mengen von mindestens 1 bis zu 30 Gew.%, bezogen auf die Gesamtmenge des strahlungsempfindlichen Gemisches enthalten ist.

Als in Gegenwart von Säure zur Kondensation befähigte organische Verbindung (c) kommen insbesondere Verbindungen der allgemeinen Formel II

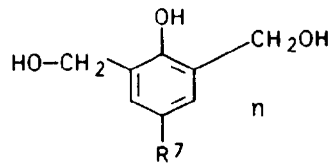 (II),

worin $R^7$ für Alkyl mit 1 bis 4 Kohlenstoffatomen steht und n = 1 bis 10, in Betracht, die im allgemeinen in Mengen von mindestens 3 bis zu 30 Gew.%, bezogen auf die Gesamtmenge des strahlungsempfindlichen Gemisches, eingesetzt werden.

Das erfindungsgemäße Gemisch kann zusätzlich einen Sensibilisator enthalten, der Strahlung absorbiert und auf Komponente (b) überträgt, sowie bis zu 1 Gew.% an Zusatzstoffen aus der Gruppe der Haftvermittler, Tenside und/oder Farbstoff.

Gegenstand der vorliegenden Erfindung ist außerdem ein Verfahren zur Herstellung lichtempfindlicher Beschichtungsmaterialien, das dadurch gekennzeichnet ist, daß ein erfindungsgemäßes strahlungsempfindliches Gemisch eingesetzt wird, sowie ein Verfahren zur Herstellung von Reliefstrukturen durch Auftragen eines strahlungsempfindlichen Gemisches in einer Schichtdicke von 0,1 bis 5 µm auf ein in üblicher Weise vorbehandeltes Substrat, Trocknen bei Temperaturen von 70 bis 120°C, bildmäßiges Belichten, Erhitzen auf Temperaturen von 70 bis 160°C und Entwickeln mit einer wäßrig-alkalischen Lösung, das dadurch gekennzeichnet ist, daß ein erfindungsgemäßes strahlungsempfindliches Gemisch eingesetzt wird.

Die erfindungsgemäßen strahlungsempfindlichen Gemische zeichnen sich durch hohe Empfindlichkeit sowie gute Struktureigenschaften, insbesondere sehr gute Haftung auf Siliciumoxidoberflächen aus.

Zu den strahlungsempfindlichen Gemischen, ihren Aufbaukomponenten und ihrer Verwendung ist im einzelnen folgendes auszuführen.

a) Als in Wasser unlösliche, in wäßrig-alkalischen Lösungen lösliches mindestens eine phenolische Hydroxylgruppe enthaltendes Bindemittel kommen in Frage phenolische Harze, bevorzugt solche, deren ortho- und/oder para-Stellungen an den Phenylresten zu mindestens 20 % vorzugsweise bis zu 66 %, frei von Substituenten sind, wie z. B. Novolake mit mittleren Molekulargewichten $\overline{M}_w$ zwischen 200 und 5 000, vorzugsweise zwischen 200 und 2000, beispielsweise Novolake auf Basis von p-Kresol/Formaldehyd, insbesondere Poly-(p-hydroxistyrole), Poly-(p-hydroxi-α-methylstyrole), beispielsweise mit mittleren Molekulargewichten $\overline{M}_w$ zwischen 200 und 30 000, vorzugsweise 1000 bis 10 000, sowie Gemische derartiger phenolischer Harze.

Als Novolake kommen beispielsweise auch solche Novolake in Frage, wie sie in Novolak Resins Used in Positiv Resist Systems von T. Pampalone in Solid State Technology, June 1984, Seite 115 bis 120, beschrieben sind. Für spezielle Anwendungen, z. B. für Belichtung im kurzwelligen UV-Gebiet kommen bevorzugt Novolake aus p-Kresol und Formaldehyd in Frage.

Bevorzugt als Komponente (a) ist Poly-(p-hydroxystyrol).

Die erfindungsgemäßen strahlungsempfindlichen Gemische enthalten Komponente (a) im allgemeinen in Mengen von 50 bis 95, vorzugsweise 70 bis 90 Gewichtsprozent der Gesamtmenge des strahlungsempfindlichen Gemisches.

Als Säurespender (b) eignen sich alle Verbindungen mit mindestens einer phenolischen Hydroxylgruppe, welche unter Bestrahlung eine starke Säure bilden. Bevorzugt zur kurzwelligen Bestrahlung sind jedoch Sulfoniumsalze der allgemeinen Formel (I)

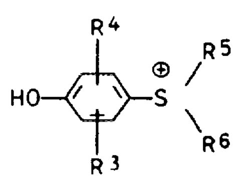 (I),

worin $R^3$ und $R^4$ untereinander gleich oder verschieden sind und für H, OH, Alkyl mit 1 bis 4, vorzugsweise 1 Kohlenstoffatom oder Alkoxi mit 1 bis 4 Kohlenstoffatomen, vorzugsweise Methoxi oder Ethoxi stehen, $R^5$ und $R^6$ untereinander gleich oder verschieden sind und für Alkyl mit 1 bis 3 Kohlenstoffatomen wie z.B. Methyl, Ethyl, Phenyl oder den Rest

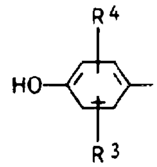

stehen und $X^{\ominus}$ = $AsF_6^{\ominus}$, $SbF_6^{\ominus}$, $PF_6^{\ominus}$, $ClO_4^{\ominus}$, $BF_4^{\ominus}$ und/oder $CF_3SO_3^{\ominus}$ (= Triflat).

Beispiele für besonders vorteilhafte Sulfoniumsalze sind

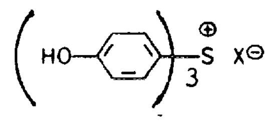

,

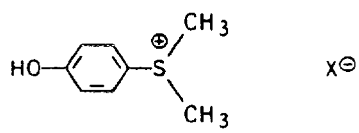

und

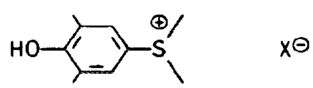

mit $AsF_6^{\ominus}$, $PF_6^{\ominus}$, $CF_3SO_3^{\ominus}$ als $X^{\ominus}$ Auch andere Säurespender können als Komponente (b) eingesetzt werden, beispielsweise entsprechende Jodoniumverbindungen mit phenolischen Hydroxylgruppen.

Komponente (b) ist im erfindungsgemäßen strahlungsempfindlichen Gemisch im allgemeinen in Mengen von mindestens 1 bis zu 30, vorzugsweise 3 bis 15 Gewichtsprozent, bezogen auf die Gesamtmenge des strahlungsempfindlichen Gemisches, enthalten.

Als geeignete, in Gegenwart von Säure zur Kondensation befähigte organische Verbindungen (c) kommen vorzugsweise Verbindungen der allgemeinen Formel (III)

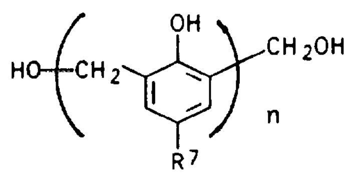

(III),

worin $R^7$ für Alkyl mit 1 bis 4 Kohlenstoffatomen, vorzugsweise Methyl, steht und n = 1 bis 10, vorzugsweise 1 ist, in Betracht. Derartige organische Verbindungen (c) kann man beispielsweise durch Umsetzung von Phenol mit Formaldehyd unter alkalischen Bedingungen erhalten (vgl. auch Ruderman, Ind. eng. Chem. Anal. 18, 753 (1946) sowie Auwers, Berichte 40, 2524 (1907)).

Komponente (c) ist im erfindungsgemäßen strahlungsempfindlichen Gemisch im allgemeinen in einer Menge von mindestens 3 bis zu 30, vorzugsweise 5 bis 25 Gew.%, bezogen auf die Gesamtmenge des strahlungsempfindlichen Gemisches enthalten, wobei die Summe der unter (a), (b) und (c) genannten Prozentzahlen jeweils 100 ist.

Die erfindungsgemäßen Gemische werden bevorzugt in einem organischen Lösungsmittel gelöst, wobei der Feststoffgehalt im allgemeinen im Bereich zwischen 5 und 40 Gew.-% liegt. Als Lösungsmittel kommen bevorzugt aliphatische Ketone, Ether, sowie Mischungen derselben in Frage, besonders Ethyl-cellosolve, Butylglykol, Methyl-cellosolve und 1-Methoxy-2-propanol, Alkylenglykol-alkylether-ester, wie beispielsweise Methyl-cellosolveacetat, Ethyl-cellosolve-acetat, Methyl-propylenglykol-acetat -acetat und Ethyl-propylenglykol-acetat, Ketone wie beispielsweise Cyclohexanon, Cyclopentanon und Methyl-ethyl-keton sowie Acetate, wie Butylacetat und Aromaten, wie Toluol und xylol. Die Auswahl der entsprechenden Lösungsmittel, sowie deren Mischung richtet sich nach der Wahl des jeweiligen phenolischen Polymers, Novolaks und der photoempfindlichen Komponente.

Weiterhin können andere Zusätze wie Haftvermittler, Netzmittel, Farbstoffe und Weichmacher zugesetzt werden.

Gegebenenfalls können auch Sensibilisatoren in geringen Mengen zugesetzt werden, um die Verbindungen im längerwelligen UV- bis hin zum sichtbaren Bereich zu sensibilisieren. Polycyclische Aromaten, wie Pyren und Perylen sind dafür bevorzugt, jedoch können auch andere Farbstoffe, die als Sensibilisatoren wirken, verwendet werden.

Die Lösung des erfindungsgemäßen strahlungsempfindlichen Gemisches kann durch ein Filter mit einem Porendurchmesser von 0,2 µm filtriert werden.

Durch Aufschleudern der Lösung des erfindungsgemäßen strahlungsempfindlichen Gemisches (= Resistlösung) bei Umdrehungszahlen zwischen 1000 und 10 000 U/min läßt sich ein Resistfilm einer Schichtdicke von 0,1 bis 5 µm auf einem Wafer (z.B. ein an der Oberfläche oxidierter Silicium-Wafer) erzeugen. Der so beschichtete Wafer wird dann zwischen 1 und 5 Minuten bei 90°C bzw. 80°C getrocknet (z.B. auf einer Heizplatte).

Besondere Vorteile des erfindungsgemäßen strahlungsempfindlichen Gemisches sind seine ausgezeichnete Reproduzierbarkeit und die sehr guten Struktureigenschaften der damit hergestellten Reliefs im Submikronbereich.

Die in den folgenden Beispielen angegebenen Teile und Prozente sind, soweit nicht anders angegebenen, Gewichtsteile bzw. Gewichtsprozente.

Beispiel 1

Eine Photoresistlösung wird aus 85 Teilen Poly-(p-hydroxystyrol) (der Fa. Polysciences, $\overline{M}_w$ = 1500-7000), 5 Teilen Tri-(p-hydroxyphenyl)sulfoniumhexafluoroarsenat, 10 Teilen 2,6-Dimethylol-p-kresol und 280 Teilen Methylglykolacetat hergestellt. Die Lösung wird anschließend durch einen Filter mit einem Porendurchmesser von 0,2 µm filtriert.

Die Resistlösung wird auf einen oxidierten Siliciumwafer in einer Schichtdicke von 1 µm aufgeschleudert, auf einer Heizplatte eine Minute bei 90°C getrocknet und anschließend mit einer Testmaske im Kontakt-Verfahren 2 Sekunden mit Excimerlaser der Wellenlänge $\lambda$ = 248 nm belichtet. Danach wird der Wafer 1 Minute bei 120°C ausgeheizt und mit einem Entwickler von pH-Wert 12,5 bis 14,5 entwickelt. Die Empfindlichkeit für 1 µm-Schichtdicke beträgt ~ 20 mJ/$cm^2$.

Beispiel 2

Eine Photoresistlösung wird aus 88 Teilen p-Kresol-Formaldehyd-Novolak ($\overline{M}_w$ = 200-300), 3 Teilen Tri-(p-hydroxyphenyl)sulfoniumhexafluoroarsenat, 9 Teilen 2,6-Dimethylol-p-kresol und 280 Teilen Cyclohexanon hergestellt. Es wird wie in Beispiel 1 verfahren. Die Empfindlichkeit für 1 µm Schichtdicke beträgt ~ 50 mJ/$cm^2$.

Beispiel 3

Eine Photoresistlösung wird aus 85 Teilen p-Methoxyphenol-Formaldehyd-Novolak ($\overline{M}_w$ = 1000-1500), 6 Teilen Tri-(p-hydroxyphenyl)sulfoniumtriflat, 9 Teilen 2,6-Dimethylol-p-kresol und 280 Teilen Diglyme (= Diethylenglykoldimethylether) hergestellt. Es wird wie in Beispiel 1 verfahren. Die Empfindlichkeit für 1 µm-Schichtdicke beträgt ~ 30 mJ/$cm^2$.

**Patentansprüche**

**1.** Strahlungsempfindliches Gemisch, im wesentlichen bestehend aus

(a) einem in Wasser unlöslichen, in wäßrig-alkalischen Lösungen löslichen Bindemittel oder Bindemittelgemisch,

(b) einer bei Bestrahlung eine starke Säure bildenden Verbindung und

(c) mindestens einer in Gegenwart von Säure zur Kondensation befähigten organischen Verbindung,
dadurch gekennzeichnet, daß jede der Komponenten (a), (b) und (c) mindestens eine phenolische Hydroxylgruppe enthält.

**2.** Strahlungsempfindliches Gemisch nach Anspruch 1, dadurch gekennzeichnet, daß das Bindemittel (a) ein phenolisches Harz ist, das an den Phenolkernen eine oder mehrere freie o- und/oder p-Stellungen aufweist.

**3.** Strahlungsempfindliches Gemisch nach Anspruch 1 oder 2, dadurch gekennzeichnet, daß das Bindemittel (a) ein kurzkettiger p-Kresol/Formaldehyd-Novolak mit einem mittleren Molekulargewicht $\overline{M}_w$ zwischen 150 und 1500 ist.

**4.** Strahlungsempfindliches Gemisch nach Anspruch 1 oder 2, dadurch gekennzeichnet, daß das Bindemittel (a) ein p-substituierter Kresol/Formaldehyd-Novolak ist, der im wesentlichen aus Einheiten der allgemeinen Formeln

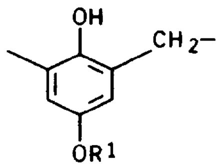 und 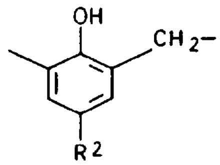

besteht, worin $R^1$ für Alkyl, Aryl oder Aralkyl,

$R^2$ für $OR^1$, Alkyl oder Aralkyl stehen,
und ein mittleres Molekulargewicht $\overline{M}_w$ zwischen 200 und 5000 aufweist.

**5.** Strahlungsempfindliches Gemisch nach einem der Ansprüche 1 oder 2, dadurch gekennzeichnet, daß das Bindemittel (a) ein Poly-(p-hydroxistyrol) oder Poly-(p-hydroxi-α-methylstyrol) mit mittleren Molekulargewichten $\overline{M}_w$ zwischen 200 und 30.000 ist.

**6.** Strahlungsempfindliches Gemisch nach Anspruch 1 oder 2, dadurch gekennzeichnet, daß das Bindemittel (a) ein Gemisch aus mindesten zwei der in den Ansprüchen 2 bis 5 genannten Bindemittel ist.

**7.** Strahlungsempfindliches Gemisch nach einem der vorhergehenden Ansprüche, dadurch gekennzeichnet, daß das Bindemittel (a) in einer Menge von 50 bis 95 Gew.%, bezogen auf die Gesamtmenge des strahlungsempfindlichen Gemisches, enthalten ist.

**8.** Strahlungsempfindliches Gemisch nach einem der vorhergehenden Ansprüche, dadurch gekennzeichnet, daß als bei Bestrahlung eine starke Säure bildenden Verbindung (b) ein Oniumsalz der allgemeinen Formel (I)

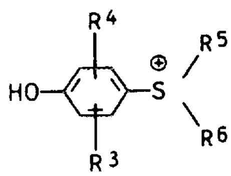 $X^{\ominus}$ (I),

worin $R^3$ und $R^4$ untereinander gleich oder verschieden sind und für H, OH, Alkyl oder Alkoxi mit 1 bis 4 Kohlenstoffatomen stehen, $R^4$ und $R^5$ untereinander gleich oder verschieden sind und für Methyl, Ethyl, Phenyl oder den Rest

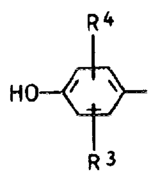

stehen und
$X^{\ominus}$ für $AsF_6^{\ominus}$, $PF_6^{\ominus}$ , $SbF_6^{\ominus}$, $BF_4^{\ominus}$ oder $CF_3SO_3^{\ominus}$ steht, eingesetzt wird.

**9.** Strahlungsempfindliches Gemisch nach einem der vorhergehenden Ansprüche, dadurch gekennzeichnet, daß Komponente (b) in einer Menge von mindestens 1 bis zu 30 Gew.%, bezogen auf die Gesamtmenge des strahlungsempfindlichen Gemisches enthalten ist.

**10.** Strahlungsempfindliches Gemisch nach einem der vorhergehenden Ansprüche, dadurch gekennzeichnet, daß als in Gegenwart von Säure zur Kondensation befähigte organische Verbindung (c) eine Verbindung der allgemeinen Formel (II)

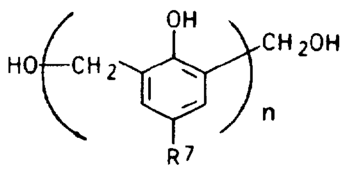 (II),

worin $R^7$ für Alkyl mit 1 bis 4 Kohlenstoffatomen steht und n = 1 bis 10, eingesetzt wird.

**11.** Strahlungsempfindliches Gemisch nach einem der vorhergehenden Ansprüche, dadurch gekennzeichnet, daß Komponente (c) in einer Menge von mindestens 3 bis zu 30 Gew.%, bezogen auf die Gesamtmenge des strahlungsempfindlichen Gemisches, enthalten ist.

**12.** Strahlungsempfindliches Gemisch nach einem der vorhergehenden Ansprüche, dadurch gekennzeichnet, daß es zusätzlich einen Sensibilisator enthält, der Strahlung absorbiert und auf Komponente (b) überträgt.

**13.** Strahlungsempfindliches Gemisch nach einem der vorhergehenden Ansprüche, dadurch gekennzeichnet, daß es bis zu 1 Gew.% an Zusatzstoffen aus der Gruppe der Haftvermittler, Tenside und/oder Farbstoffe, bezogen auf die Gesamtmenge des strahlungsempfindlichen Gemisches, enthält.

**14.** Verfahren zur Herstellung lichtempfindlicher Beschichtungsmaterialien, dadurch gekennzeichnet, daß ein strahlungsempfindliches Gemisch gemäß einem der vorhergehenden Ansprüche eingesetzt wird.

**15.** Verfahren zur Herstellung von Reliefstrukturen durch Auftragen eines strahlungsempfindlichen Gemisches in einer Schichtdicke von 0,1 bis 5 µm auf ein in üblicher Weise vorbehandeltes Substrat, Trocknen bei Temperaturen von 70 bis 120°C, bildmäßiges Belichten, Erhitzen auf Temperaturen von 70 bis 160°C und Entwickeln mit einer wäßrigalkalischen Lösung, dadurch gekennzeichnet, daß ein strahlungsempfindliches Gemisch nach einem der Ansprüche 1 bis 13 eingesetzt wird.

**Claims**

**1.** A radiation-sensitive mixture essentially consisting of

(a) a binder or binder mixture which is insoluble in water but soluble in aqueous alkaline solutions,
(b) a compound which forms a strong acid on exposure to radiation and
(c) one or more organic compounds which are capable of undergoing condensation in the presence of acid,
wherein each of the components (a), (b) and (c) contains one or more phenolic hydroxyl groups.

**2.** A radiation-sensitive mixture as claimed in claim 1, wherein the binder (a) is a phenolic resin which has one or more free o- and/or p-positions on the phenol nuclei.

**3.** A radiation-sensitive mixture as claimed in claim 1 or 2, wherein the binder (a) is a short-chain p-cresol/formaldehyde novolak having a mean molecular weight $\overline{M}_w$ of from 150 to 1,500.

**4.** A radiation-sensitive mixture as claimed in claim 1 or 2, wherein the binder (a) is a p-substituted cresol/formaldehyde novolak which essentially consists of units of the formulae

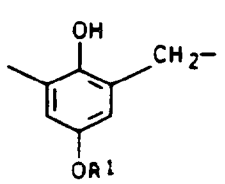 and 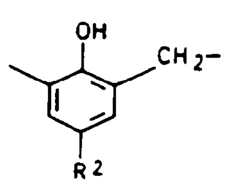

where $R^1$ is alkyl, aryl or aralkyl and $R^2$ is $OR^1$, alkyl or aralkyl, and has a mean molecular weight $\overline{M}_w$ of from 200 to 5,000.

**5.** A radiation-sensitive mixture as claimed in claim 1 or 2, wherein the binder (a) is a poly-(p-hydroxystyrene) or poly-(p-hydroxy-a-methylstyrene) having a mean molecular weight $\overline{M}_w$ of from 200 to 30,000.

6. A radiation-sensitive mixture as claimed in claim 1 or 2, wherein the binder (a) is a mixture of two or more of the binders stated in claim 2 or 3 or 4 or 5.

7. A radiation-sensitive mixture as claimed in any of the preceding claims, wherein the binder (a) is present in an amount of from 50 to 95% by weight, based on the total amount of the radiation-sensitive mixture.

8. A radiation-sensitive mixture as claimed in any of the preceding claims, wherein an onium salt of the formula (I)

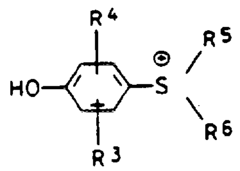 $X^{\ominus}$ (I)

where $R^3$ and $R^4$ are identical or different and are each H, OH, alkyl or alkoxy of 1 to 4 carbon atoms, $R^4$ and $R^5$ are identical or different and are each methyl, ethyl, phenyl or the radical

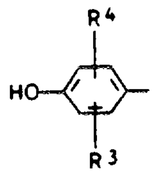

and $X^{\ominus}$ is $AsF_6^{\ominus}$, $PF_6^{\ominus}$ , $SbF_6^{\ominus}$, $BF_4^{\ominus}$ or $CF_3SO_3^{\ominus}$, is used as the compound (b) which forms a strong acid on exposure to radiation.

9. A radiation-sensitive mixture as claimed in any of the preceding claims, wherein component (b) is present in an amount of from not less than 1 to 30% by weight, based on the total amount of the radiation-sensitive mixture.

10. A radiation-sensitive mixture as claimed in any of the preceding claims, wherein a compound of the formula (II)

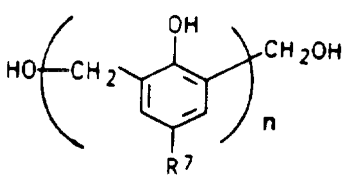 (II)

where $R^7$ is alkyl of 1 to 4 carbon atoms and n is from 1 to 10, is used as the organic compound (c) capable of undergoing condensation in the presence of an acid.

11. A radiation-sensitive mixture as claimed in any of the preceding claims, wherein component (c) is present in an amount of from not less than 3 to 30% by weight, based on the total amount of the radiation-sensitive mixture.

12. A radiation-sensitive mixture as claimed in any of the preceding claims, which additionally contains a sensitizer which absorbs radiation and transfers it to component (b).

13. A radiation-sensitive mixture as claimed in any of the preceding claims, which contains not more than 1% by weight, based on the total amount of the radiation-sensitive mixture, of additives from the group consisting of the adhesion promoters, surfactants and/or dyes.

14. A process for the preparation of a photosensitive coating material, wherein a radiation-sensitive mixture as claimed in any of the preceding claims is used.

15. A process for the production of a relief structure by application of a radiation-sensitive mixture in a layer thickness of from 0.1 to 5 µm to a conventionally pretreated substrate, drying at from 70 to 120°C, imagewise exposure, heating to 70-160°C and development using an aqueous alkaline solution, wherein a radiation-sensitive mixture as

claimed in claim 1 or 2 or 3 or 4 or 5 or 6 or 7 or 8 or 9 or 10 or 11 or 12 or 13 is used.

## Revendications

1. Mélange sensible au rayonnement, constitué essentiellement :

   (a) d'un liant ou un mélange de liants, insoluble dans l'eau, soluble dans des conditions alcalino-aqueuses,

   (b) d'une combinaison formant un acide fort par irradiation, et

   (c) d'au moins une combinaison organique susceptible d'entrer en condensation, en présence d'acide, caractérisé en ce que chacun des composants (a), (b), et (c) contient au moins un groupe hydroxyle phénolique.

2. Mélange sensible au rayonnement selon la revendication 1, caractérisé en ce que le liant (a) est une résine phénolique, présentant une ou plusieurs positions libres o et/ou p sur les noyaux phénoliques.

3. Mélange sensible au rayonnement selon la revendication 1 ou 2, caractérisé en ce que le liant (a) est un p-crésol/formaldéhyde-Novolaque à chaîne courte, avec un poids moléculaire moyen $\overline{M}_w$ compris entre 150 et 1500.

4. Mélange sensible au rayonnement selon la revendication 1 ou 2, caractérisé en ce que le liant (a) est un crésol substitué en p/formaldéhyde-Novolaque, constitué essentiellement d'unités de formules générales

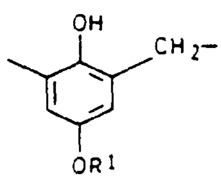
et
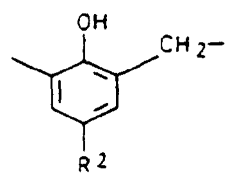

   où $R^1$ est un radical alkyle, aryle, ou aralkyle,

   où $R^2$ signifie $OR^1$, un radical alkyle ou aralkyle,
   et présentant un poids moléculaire moyen $\overline{M}_w$ compris entre 200 et 5000.

5. Mélange sensible au rayonnement selon l'une des revendications 1 ou 2, caractérisé en ce que le liant (a) est un poly-(p-hydroxystyrène) ou un poly-(p-hydroxy-a-méthylstyrène), à poids moléculaires moyens $\overline{M}_w$ compris entre 200 et 30000.

6. Mélange sensible au rayonnement selon l'une des revendications 1 ou 2, caractérisé en ce que le liant (a) est un mélange d'au moins deux des liants cités aux revendications 2 à 5.

7. Mélange sensible au rayonnement selon l'une des revendications précédentes, caractérisé en ce que le liant (a) est contenu en quantité de 50 à 95 % en poids rapporté à la quantité totale de mélange sensible au rayonnement.

8. Mélange sensible au rayonnement selon l'une des revendications précédentes, caractérisé en ce qu'est utilisé, comme combinaison (b) formant un acide fort par l'irradiation, un sel d'onium de formule générale (I)

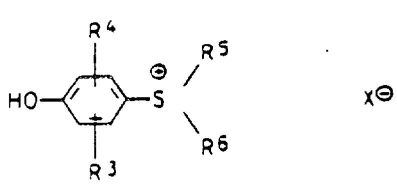
(I),

dans laquelle $R^3$ et $R^4$, identiques entre eux ou différents, sont H, OH, un radical alkyle ou alcoxy avec de 1 à 4 atomes de carbone, $R^4$ et $R^5$, identiques entre eux ou différents, sont un radical méthyle, éthyle, phényle ou le reste

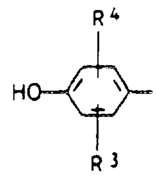

et

$X^{\ominus}$ est $AsF_6^{\ominus}$, $PF_6^{\ominus}$, $SbF_6^{\ominus}$, $BF_4^{\ominus}$ ou $CF_3SO_3^{\ominus}$.

**9.** Mélange sensible au rayonnement selon l'une des revendications précédentes, caractérisé en ce que le composant (b) est contenu en une quantité d'au moins 1 à 30 % en poids par rapport à la quantité totale de mélange sensible au rayonnement.

**10.** Mélange sensible au rayonnement selon l'une des revendications précédentes, caractérisé en ce qu'est utilisée, comme combinaison (c) organique susceptible de condensation en présence d'un acide, une combinaison de formule générale (II)

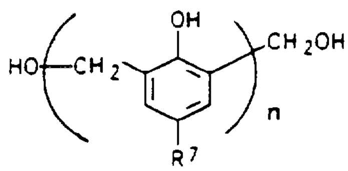

(II),

dans laquelle $R^7$ est un radical alkyle contenant de 1 à 4 atomes de carbone et n = 1 à 10.

**11.** Mélange sensible au rayonnement selon l'une des revendications précédentes, caractérisé en ce que le composant (c) est contenu en une quantité d'au moins 3 à 30 % en poids, par rapport à la quantité totale de mélange sensible au rayonnement.

**12.** Mélange sensible au rayonnement selon l'une des revendications précédentes, caractérisé en ce qu'il contient en plus un sensibilisateur, absorbant le rayonnement et le transmettant au composant (b).

**13.** Mélange sensible au rayonnement selon l'une des revendications précédentes, caractérisé en ce qu'il contient jusqu'à 1 % en poids d'additif venant du groupe des agents d'adhésion, tensioactifs et/ou colorants, par rapport à la quantité totale de mélange sensible au rayonnement.

**14.** Procédé de fabrication de matériau de revêtement sensible à la lumière, caractérisé en ce qu'est utilisé un mélange sensible au rayonnement selon l'une des revendications précédentes.

**15.** Procédé de fabrication de structure en relief par application d'un mélange sensible au rayonnement, en une épaisseur de couche allant de 0,1 à 5 µm sur un substrat ayant été pré-traité de la manière usuelle, séchage à des températures de 70 à 120°C, exposition à la lumière pour former une image, chauffage à des températures de 70 à 160°C et développement avec une solution alcalino-aqueuse, caractérisé en ce qu'est utilisé un mélange sensible au rayonnement selon l'une des revendications 1 à 13.